# EUROPÄISCHE PATENTSCHRIFT

(11) **EP 2 947 473 B1**
(45) Veröffentlichungstag und Bekanntmachung des Hinweises auf die Patenterteilung: **25.05.2022**
(21) Anmeldenummer: 15164841.7
(22) Anmeldetag: 23.04.2015
(51) Int. Cl.: G01R 33/28, G01R 33/36

(54) **ERSTELLUNG EINES MR-BILDES MIT HILFE EINER KOMBINATION AUS EINER GANZKÖRPERSPULE UND EINER LOKALEN SENDESPULE**
CREATION OF AN MR IMAGE WITH THE AID OF A COMBINATION OF A WHOLE BODY COIL AND A LOCAL TRANSMISSION COIL
FABRICATION D'UNE IMAGE MR À L'AIDE D'UNE COMBINAISON D'UNE BOBINE AU CORPS ENTIER ET D'UNE BOBINE D'EXCITATION LOCALE

(30) Priorität: 22.05.2014 DE 102014209783
(43) Veröffentlichungstag der Anmeldung: 25.11.2015
(73) Patentinhaber: Siemens Healthcare GmbH, 91052 Erlangen (DE)
(72) Erfinder: Nittka, Mathias, 91083 Baiersdorf (DE)

(56) Entgegenhaltungen:
- WO-A1-99/27390
- DE-A1-102006 046 044
- DE-A1-102007 057 495
- US-A- 4 629 988
- US-A1- 2011 128 000
- US-B1- 6 975 114
- OVERALL W ET AL: "Optically coupled Op Amp transmitter for use with interventional microcoils", PROCEEDINGS OF THE INTERNATIONAL SOCIETY FOR MAGNETIC RESONANCE IN MEDICINE, ISMRM, 13TH SCIENTIFIC MEETING AND EXHIBITION, MIAMI BEACH, FLORIDA, USA, 7-13 MAY 2005, 23. April 2005 (2005-04-23), Seite 2655, XP040595339,
- AVDIEVICH N, HETHERINGTON HH: "Improved homogeneity of the transmit field due to simultaneous transmission with phased arrays and volume coils", PROCEEDINGS OF THE INTERNATIONAL SOCIETY FOR MAGNETIC RESONANCE IN MEDICINE, 14TH SCIENTIFIC MEETING AND EXHIBITION, SEATTLE, WASHINGTON, USA, 6-12 MAY 2006, 22. April 2006 (2006-04-22), Seite 2567, XP040598084,

## Beschreibung

Die vorliegende Erfindung betrifft ein Verfahren und eine Vorrichtung, die es erlauben, ein Untersuchungsobjekt in einer MR-Anlage durch eine spezielle MR-Bildgebungssequenz in einer kombinierten Vorrichtung bestehend aus einer Ganzkörperspule und einer lokalen Sendespule so anzuregen, dass bei hoher Güte des Signals die SAR (spezifische Absorptionsrate) im Untersuchungsobjekt minimiert wird.

In der medizinischen MR-Diagnostik existieren verschiedene Methoden um die Signalqualität und den Kontrast des Signals zu maximieren. Diese Methoden erfordern in der Regel die Benutzung von magnetischen HF-Feldern hoher Feldstärke. Insbesondere bei den HF-Feldern, die zu einer Anregung eines Signals und zu einer Refokussierung über das gesamte Volumen des Untersuchungsobjekts verwendet werden, tritt dabei eine teilweise Absorption der eingestrahlten Energie durch das Untersuchungsobjekt und damit eine Erwärmung ein. Ein Maß für diese Absorption bzw. Erwärmung ist die spezifische Absorptionsrate (SAR). Um eine zu starke Erwärmung zu verhindern, existieren gesetzliche Grenzwerte für die SAR, die festlegen, welche maximale Energieleistung in einem Objekt einer bestimmten Masse deponiert werden soll. Um die Überschreitung dieser Grenzwerte zu vermeiden, werden nach dem aktuellen Stand der Technik MR-Anlagen eingesetzt, die für bestimmte Teile eines Untersuchungsobjekts lokale Volumenspulen zur HF-Felderzeugung einsetzen. Diese sind räumlich begrenzt und weisen daher eine geringere SAR auf. Sie sind geeignet für Körperbereiche, die komplett von einer Volumenspule umschlossen werden können. Beispiele hierfür sind lokale Volumenspulen für ein Knie oder den Kopf. Außerdem können lokale Volumenspulen durch die Reduktion des zu kodierenden Messbereichs eine Reduktion der Kodierungszeit erreichen, was die Gesamtdauer der Untersuchung erheblich verkürzen kann.

Auch bei speziellen Bildgebungen, beispielsweise bei Implantaten, chemical Shift Artefakten oder Spektroskopie, haben lokale Sendespulen Vorteile, die räumlich begrenzt möglichst hohe Amplituden und Bandbreiten erzeugen können.

An den Rändern des Feldes der lokalen Volumenspule zeigt sich jedoch häufig bereits ein sichtbarer Abfall der Feldstärke.

Handelt es sich bei dem Untersuchungsobjekt hingegen um solche Körperteile die nicht oder nur schwer umschlossen werden können, können lokale Volumenspulen nicht verwendet werden. Daher müssen niedrigere Intensitäten für die Refokussierungspulse in Kauf genommen werden, was zu einer Einschränkung in der Qualität der Bildgebung führt.

Die bisher bekannten Verfahren zur Maximierung der Qualität und des Kontrasts des Signals erfordern einerseits möglichst hohe HF-Feldstärken, andererseits tritt dabei aber eine zunehmende Erwärmung des Untersuchungsobjekts ein.

Die Verwendung von sendenden TX-Oberflächenspulen zur Anregung eines begrenzten Teil des Untersuchungsbereichs ermöglichen es, eine niedrige SAR zu erreichen, hat jedoch den gravierenden Nachteil, dass sie kein ausreichend homogenes Anregungsfeld erzeugen können. Ein möglichst homogenes Anregungsfeld ist aber deshalb notwendig, weil nur dadurch ein MR-Bild mit einem hohen Kontrast und einer hohen Qualität erzeugt werden kann. Daher werden sendende TX-Oberflächenspulen für die Anregung des Untersuchungsobjekt in der Praxis kaum verwendet. Aus Sicht der Bildgebungssequenz führt ein inhomogenes Anregungsfeld zu einer Variation des Flipwinkels über das Bildgebungsvolumen, was wiederum den Bildkontrast und das Signal-Rausch Verhältnis negativ beeinflusst. Es ist aber wünschenswert, gleichzeitig einen möglichst konstanten, gut definierten Kontrast und ein möglichst hohes Signal-Rausch Verhältnis zu erhalten.

Die Verwendung räumlich begrenzter Volumenspulen löst dieses Problem, jedoch können damit nur solche Teile des Untersuchungsobjekts untersucht werden, die komplett von der Volumenspule umschlossen werden können. Andere Teile, wie z.B. eine Schulter, die Hüfte oder die Wirbelsäule, können von Volumenspulen nicht umschlossen werden, wodurch die Untersuchung basierend auf einer räumlich begrenzten Spule erheblich erschwert wird.

US 6 975 114 B1 offenbart ein Verfahren zur Anregung der Spins mit Verwendung von zwei HF-Spulen zur Erzeugung einer homogenen räumlichen Anregung.

DE 10 2006 046044 A1 beschreibt eine Hochfrequenzsendeanordnung mit einer Ganzkörperantenne und einem Einschub, wobei ein resultierendes B1-Feld mit mehreren Moden durch eine Kombination der Ganzkörperantenne und des Einschubs erzeugt werden.

DE 10 2007 057495 A1 beschreibt eine Hochfrequenzsendeeinrichtung mit einer Ganzkörperspule und einer lokalen Antenne, die zur Markierung von arteriellem Blut verwendet wird, wobei ein gemeinsamer Hochfrequenzverstärker verwendet wird.

Die WO 99/27390 beschreibt eine MR-Anlage mit einer Körperspule und einer Katheterantenne, wobei HF-Pulse abwechselnd von der Körperspule und der Katheterantenne eingestrahlt werden.

Die vorliegende Erfindung stellt sich die Aufgabe, ein Verfahren bereitzustellen, das die Anregung beliebiger Teile des Untersuchungsobjekts unter Einhaltung der vorgeschriebenen Grenzwerte für die SAR ermöglicht und gleichzeitig eine hohe Qualität der Bildgebung erreicht.

Erfindungsgemäß wird diese Aufgabe durch ein Verfahren zur Erstellung eines MR-Bildes eines Untersuchungsobjekts nach Anspruch 1 sowie eine MR-Anlage zur Erstellung eines MR-Bildes nach Anspruch 5 gelöst. Die abhängigen Ansprüche definieren bevorzugte und vorteilhafte Ausführungsformen der vorliegenden Erfindung.

Zunächst wird während einer Bildgebungssequenz mindestens ein magnetischer HF-Puls über das gesamte Untersuchungsobjekt durch eine Ganzkörperspule eingestrahlt.

Der Vorteil dieses Schrittes besteht darin, dass das Einstrahlen durch die Ganzkörperspule es erlaubt, eine möglichst homogene Anregung des Untersuchungsobjekts zu erreichen.

Danach erfolgt die Einstrahlung mindestens eines HF-Pulses durch die lokale Sendespule.

Dieser Puls dient vorteilhaft dazu, die Spins, die nach der Anregung mit unterschiedlichen Phasen präzedieren und somit auseinanderlaufen, derartig gekippt werden, so dass sie wieder zusammenlaufen und damit ein Echo-Signal erzeugen können. Anschließend erfolgt das Auslesen von MR-Signalen.

Im nächsten Schritt wird aus den ausgelesenen MR-Signalen ein MR-Bild erstellt.

Erfindungsgemäß weist die Bildgebungssequenz ein Auslesemodul auf, in dem mehrere HF-Refokussierungspulse zur Erzeugung von mehreren Spinechos eingestrahlt werden, wobei alle HF-Refokussierungspulse des Auslesemoduls mit der lokalen Sendespule eingestrahlt werden. Die Kombination eines Anregungspulses mit mehreren HF-Refokussierungspulsen stellt eine Turbo-Spin-Echo Sequenz dar.

Die HF-Refokussierungspulse können in einem bevorzugten Ausführungsbeispiel derart beschaffen sein, dass sie das Untersuchungsobjekt mit einem Flipwinkel zwischen 150 und 180 Grad anregen. Der Vorteil dieses Schritts besteht darin, dass die Refokussierungspulse mit der lokalen Sendespule eingestrahlt werden und dadurch eine Absorption der eingestrahlten Energie (SAR, spezifische Absorptionsrate) durch das Untersuchungsobjekt und damit eine Erwärmung des Untersuchungsobjekts minimiert wird.

In einem weiteren bevorzugten Ausführungsbeispiel weist die Bildgebungssequenz vor dem Auslesemodul ein Präparationsmodul auf, in dem mindestens ein HF-Anregungspuls eine Magnetisierung des Untersuchungsobjekts präpariert, und der von der Ganzkörperspule eingestrahlt wird.

Der HF-Anregungspuls dreht die Spins aus einer Gleichgewichtslage um 90 Grad in die Ebene der Magnetfeldrichtung des präzedierenden Anregungspulses.

Der HF-Anregungspuls wird vorteilhaft durch die Ganzkörperspule gesendet, weil diese ein homogenes Magnetfeld ausbildet und somit der gesamte Untersuchungsbereich möglichst homogen angeregt werden kann und damit die Qualität des MR-Bildes möglichst hoch ist.

In einem weiteren Ausführungsbeispiel kann das Präparationsmodul einen HF-Präparationspuls zur Unterdrückung unerwünschter MR-Signalanteile im Auslesemodul aufweisen. Der HF-Präparationspuls wird von der Ganzkörperspule eingestrahlt. Dadurch wird vorteilhaft erreicht, dass das Untersuchungsobjekt in der MR-Bildgebung einen besseren Kontrast aufweist und der störende Einfluss unerwünschter MR-Signale reduziert wird.

Die MR-Anlage, die zur Durchführung des Verfahrens vorgeschlagen wird, arbeitet wie oben beschrieben, und umfasst eine Ganzkörperspule und eine lokale Sendespule, die ausgebildet sind, HF-Pulse zu erzeugen. Darüber hinaus umfasst die MR-Anlage eine Empfangsspule, die ausgebildet ist, die Spinechos aus dem Untersuchungsobjekt zu empfangen.

Außerdem weist die MR-Anlage eine HF-Steuereinheit auf, die die HF-Pulse der Ganzkörperspule und der lokalen Sendespule steuert. Dabei steuert die HF-Steuereinheit die Spulen so, dass die Ganzkörperspule während der Bildgebungssequenz mindestens einen HF-Puls einstrahlt und die lokale Sendespule während der Bildgebungssequenz mindestens einen HF-Puls einstrahlt.

Zusätzlich weist die MR-Anlage einen Bildrechner auf, der aus den empfangenen Spinechos ein MR-Bild berechnet.

Mit dieser Anordnung wird vorteilhaft erreicht, dass das MR-Bild eine hohe Qualität bei gleichzeitig minimierter SAR hat.

Die lokale Sendespule ist innerhalb des Untersuchungsbereichs frei positionierbar. Damit wird vorteilhaft erreicht, dass solche Teile des Untersuchungsobjekts, die mit einer lokalen Volumenspule nicht oder nur schwer zugänglich sind, mit HF-Pulsen ausgestrahlt werden können. Damit kann der Fachmann beispielsweise HF-Refokussierungspulse in einen Teil des Untersuchungsobjekts einstrahlen und somit eine Minimierung der SAR des Untersuchungsobjekts erreichen.

Die Bildgebungssequenz legt fest, wie die HF-Steuereinheit die Ganzkörperspule und die lokale Sendespule steuert und arbeitet wie oben beschrieben.

Der Benutzer der erfindungsgemäßen Vorrichtung und des Verfahrens ist somit vorteilhaft dazu in der Lage, Untersuchungsbereiche, die räumlich nicht von Volumenspulen umschlossen werden können, individuell einer Bildgebungssequenz zu unterziehen. Dabei ist die lokale Sendespule zum Einstrahlen der magnetischen Refokussierungspulse so ausgestaltet, dass das Magnetfeld räumlich begrenzt ist und nur auf den Untersuchungsbereich wirkt. Dies erlaubt dem Fachmann, bei Einhaltung der maximal erlaubten SAR die Amplituden der eingestrahlten Refokussierungspulse zu maximieren und somit die Qualität der Signale aus dem Untersuchungsbereich zu erhöhen. Gleichzeitig wird die Energieabsorption (SAR) im Untersuchungsobjekt und die damit verbundene Erwärmung des Untersuchungsobjekts minimiert.

Im Folgenden werden erfindungsgemäße Ausführungsformen im Detail mit Bezug zu den Figuren beschrieben.
Fig. 1 zeigt eine schematische Darstellung der erfindungsgemäßen MR-Anlage.
Fig. 2 zeigt eine bildliche Darstellung der verschiedenen Module und der HF-Pulse.
Fig. 3 zeigt ein Flussdiagramm zum erfindungsgemäßen Ablauf des Verfahrens Fig. 1 zeigt eine schematische Darstellung einer MR-Anlage.

Dabei erzeugt ein Grundfeldmagnet 30 ein zeitlich konstantes starkes Magnetfeld zur Polarisation bzw. Ausrichtung der Kernspins in einem Untersuchungsobjekt 20.

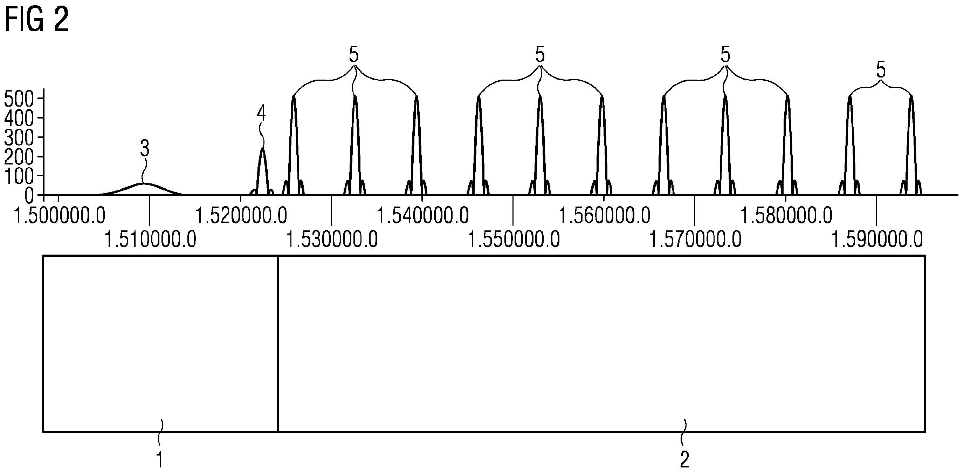

Das Untersuchungsobjekt 20 wird nun auf einem Tisch 31 in die MR-Anlage geschoben. In der MR-Anlage erzeugt eine Ganzkörperspule 21 ein HF-Feld zur Erzeugung von HF-Anregungspulsen und HF-Präparationspulsen, welche Teil des Anregungsmoduls sind, das in Fig. 2 dargestellt ist.

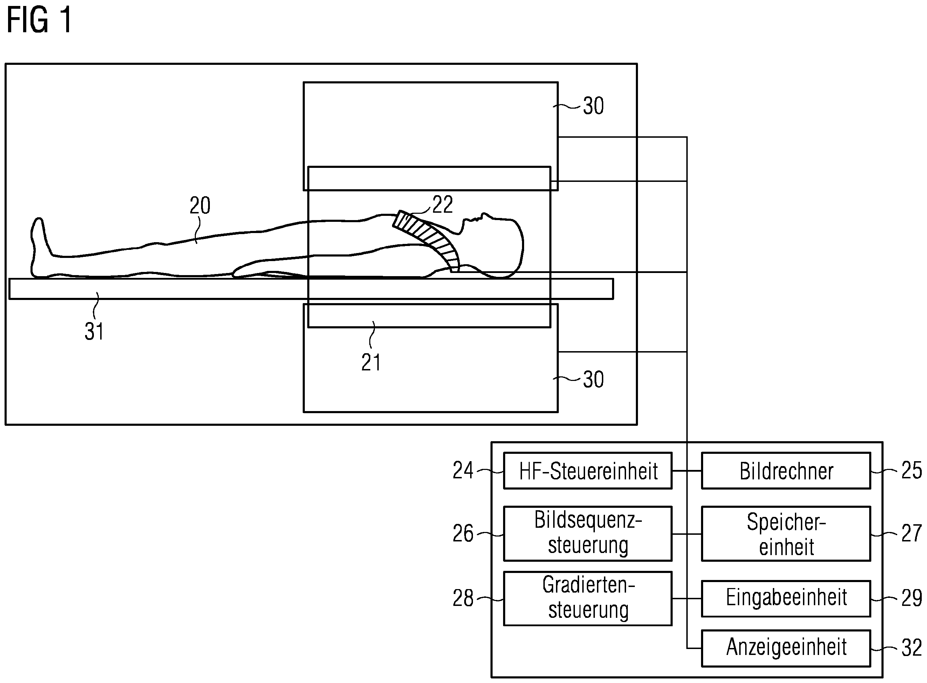

Fig. 1 zeigt weiterhin die lokale Sendespule/Empfangsspule 22, die ausgebildet ist, bestimmte Teile des Untersuchungsobjekts 20 abzudecken oder teilweise zu umschließen. Darüber hinaus ist die lokale Sendespule/Empfangsspule 22 innerhalb des Untersuchungsbereichs frei positionierbar. In der erfindungsgemäßen Ausführung der MR-Anlage wird damit erreicht, dass schwer zugängliche Teile des Untersuchungsobjekts 20 auf eine einfache Art abgedeckt werden können. Derartige schwer zugängliche Teile des Untersuchungsobjekts, wie z.B. die Wirbelsäule, eine Hüfte oder eine Schulter, können von einer fest verbauten lokalen Sendespule nicht oder nur schwer abgedeckt werden. Die freie Bewegbarkeit der lokalen Sendespule/Empfangsspule 22 kann jedoch dazu dienen, schwer zugängliche Teile des Untersuchungsobjekts 20 zu untersuchen.

Fig. 1 zeigt außerdem die Steuerung der MR-Anlage, welche eine HF-Steuereinheit 24, eine Bildsequenzsteuerung 26, eine Gradientensteuerung 28, einen Bildrechner 25, eine Speichereinheit 27, eine Anzeigeeinheit 32 und eine Eingabeeinheit 29 aufweist.

Die HF-Steuereinheit 24 steuert die die HF-Pulse der Ganzkörperspule 21 und der lokalen Sendespule/Empfangsspule 22. Dabei wählt die HF-Steuereinheit 24 die HF-Pulse so aus, dass die Ganzkörperspule und die lokale Sendespule/Empfangsspule 22 während der Bildgebungssequenz mindestens jeweils einen HF-Puls einstrahlen, wobei erfindungsgemäß alle HF-Refokussierungspulse des Auslesemoduls der Bildgebungssequenz mit der lokalen Sendespule/Empfangsspule eingestrahlt werden.

Die Bildsequenzsteuerung 26 legt die Beschaffenheit der Breiten, die Amplituden und die Anzahl der HF-Präparationspulse, der HF-Anregungspulse und der HF-Refokussierungspulse fest.

Fig. 1 zeigt außerdem eine Gradientensteuerung 28, welche dazu dient, den Gradienten des Grundfeldes zu steuern.

Um die Daten der HF-Signale zu speichern, weist die MR-Anlage eine Speichereinheit 27 auf. Für die Bedienung der MR-Anlage durch den Benutzer ist eine Eingabeeinheit 29 an die MR-Anlage gekoppelt.

Darüber hinaus existiert ein Bildrechner 25, der die HF-Signale analysiert und derart aufbereitet, dass sie in einem MR-Bild dargestellt werden können. Eine Anzeigeeinheit 32 stellt das MR-Bild dar.

Fig. 2 zeigt die verschiedenen Module und Pulse, die von der Bildgebungssequenz in der MR-Anlage erzeugt werden. Ein Präparationsmodul 1 beinhaltet zunächst einen HF-Anregungspuls 4. Dieser HF-Anregungspuls 4 ist so ausgebildet, dass er das gesamte Volumen des Untersuchungsobjekts homogen angeregt, so dass alle Spins um 90 Grad in die Ebene des Magnetfeldes des HF-Anregungspulses 4 gedreht werden. Die möglichst exakte Ausrichtung der Spins in die Ebene des Magnetfeldes führt zu einer Verbesserung der Qualität in der Bildgebung.

Fig. 2 zeigt weiterhin einen HF-Präparationspuls 3, der in einer bevorzugten Ausführungsform vor dem HF-Anregungspuls 4 eingestrahlt werden kann. Dieser HF-Präparationspuls 3 ist derart ausgebildet, dass er die Spins in bestimmten Gewebeanteilen, beispielsweise Fettgewebe, so anregt, dass sie in der gesamten Bildgebungssequenz möglichst geringe MR-Signale erzeugen. Damit werden MR-Signale aus Gewebeanteilen, die die Bildgebungssequenz stören oder nicht wichtig sind, reduziert.

Darüber hinaus zeigt Fig. 2 ein Auslesemodul 2, welches erfindungsgemäß mehrere HF-Refokussierungspulse 5 enthält. Jeder HF-Refokussierungspuls 5 dient dazu, die ausgerichteten Spins, die nach der Anregung mit unterschiedlichen Phasen präzedieren und daher auseinanderlaufen, um 150 - 180 Grad zu kippen, so dass sie wieder zusammenlaufen und so ein MR-Signal erzeugen.

In Fig. 2 ist die Beschaffenheit der HF-Präparationspulse 3, der HF-Anregungspulse 4 und der HF-Refokussierungspulse 5 genau dargestellt. Dabei haben die HF-Refokussierungspulse 5 eine möglichst hohe Amplitude und eine kurze Pulsdauer um die Qualität der HF-Signale zu erhöhen. Dabei ist die SAR (spezifische Absorptionsrate) des Untersuchungsobjekts minimiert, da sie von der lokalen Sendespule/Empfangsspule eingestrahlt wird und daher nur in einem begrenzen Teil des Untersuchungsobjekts wirkt.

Der HF-Anregungspuls 4 wird mit der Ganzkörperspule eingestrahlt und wirkt daher auf das gesamte Untersuchungsobjekt. Entsprechend kann die SAR hohe Werte erreichen, was dazu führt dass die Amplitude im Vergleich zu den HF-Refokussierungspulsen 5 geringer gewählt wird.

Mit dieser Anordnung wird vorteilhaft erreicht, dass das MR-Bild eine hohe Qualität bei gleichzeitig minimierter SAR (spezifische Absorptionsrate) erzeugt werden kann.

Der HF-Präparationspuls 3 ist so gewählt dass er unerwünschte Signale aus dem Untersuchungsobjekt ausblendet. Die Beschaffenheit des HF-Präparationspulses 3 kann in einem Ausführungsform so gewählt werden, dass eine lange Pulsdauer und eine niedrige Amplituden aufweist. Andere Ausführungsformen sind ebenfalls möglich.

Wie in der Fig. 2 dargestellt, kann die Bildgebungssequenz eine Kontrastpräparierung aufweisen durch den HF-Puls 3. Dieser HF-Puls zur Kontrasterzeugung wird mit der Ganzkörperspule gesendet, um einen möglichst homogenen Kontrast zu erzielen, während das Auslesemodul mit der Lokalspule gesendet wird, um die Vorteile der Lokalspule wie ein reduziertes SAR, ein reduziertes Bildgebungsvolumen für eine Messzeitverkürzung und eine schnellere Bildgebung durch kürzere Pulse, die eine erhöhte B1-Amplitude der Lokalspulen nutzen, zu erreichen. In einer weiteren Ausführungsform kann die Bildgebungssequenz jedoch eine schnelle Spinechosequenz sein ohne den HF-Puls 3 und nur mit den HF-Pulsen 4 und 5. Da der Anregungspuls aufgrund des geringen Flipwinkels von 90° und der geringeren Häufigkeit weniger kritisch aus Sicht von B1-Amplitude und SAR ist, wird dieser Puls vorteilhaft mit der Ganzkörperspule gesendet. Die Flipwinkel der Refokussierungspulse haben hingegen geringeren Einfluss auf die Bildqualität, da ein niedrigerer Flipwinkel zwar das Signal der direkten Spinechos reduziert, dies aber durch einen zunehmenden Anteil der Signal durch stimulierte Echos zumindest teilweise kompensiert wird. Durch die Einstrahlungen der Refokussierungspulse mit der Lokalspule kann das SAR induziert werden, wobei das gesamte SAR der Sequenz durch das SAR der Refokussierungspulse dominiert wird. Ebenso kann die Bildqualität durch kürzere Pulse mit höherer B1-Amplitude verbessert werden.

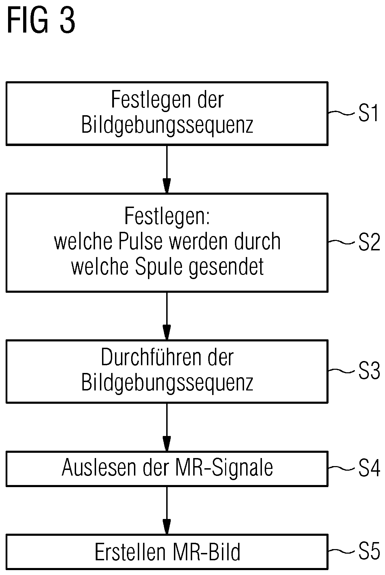

Fig. 3 zeigt ein Flussdiagramm des erfindungsgemäßen Verfahrens zur Erstellung eines MR-Bildes. Dabei wird im ersten Schritt S1 die Bildgebungssequenz festgelegt, welche die Anzahl und die Beschaffenheit der HF-Pulse festlegt. Erfindungsgemäß weist die Bildgebungssequenz ein Auslesemodul auf, in dem mehrere HF-Refokussierungspulse zur Erzeugung von mehreren Spinechos eingestrahlt werden. Im Schritt S2 bestimmt das Verfahren, ob die Ganzkörperspule oder die lokale Sendespule/Empfangsspule die verschiedenen HF-Pulse sendet, wobei erfindungsgemäß alle HF-Refokussierungspulse mit der lokalen Sendespule eingestrahlt werden. Darauf folgend wird im Schritt S3 die Bildgebungssequenz ausgeführt, wobei die im Schritt S1 festgelegte Abfolge der HF-Pulse benutzt wird. Im Schritt S4 werden die erzeugten MR-Signale ausgelesen und gespeichert. Im Schritt S5 wird schließlich das MR-Bild basierend auf den Daten aus dem Schritt S4 erstellt.

## Patentansprüche

1. Verfahren zur Erstellung eines MR-Bildes eines Untersuchungsobjekts mit einer MR-Bildgebungssequenz in einer MR-Anlage, mit folgenden Schritten:
- Einstrahlen von mindestens einem HF-Puls (3, 4) durch eine Ganzkörperspule (21) der MR-Anlage während der Bildgebungssequenz,
- Einstrahlen von mindestens einem HF-Puls (5) durch eine lokale Sendespule (22) der MR-Anlage während der Bildgebungssequenz,
- Auslesen von MR-Signalen, die durch die eingestrahlten HF-Pulse (3, 4, 5) erzeugt werden,
- Erstellen des MR-Bildes aus den ausgelesenen MR-Signalen, wobei die Bildgebungssequenz ein Auslesemodul (2) aufweist, in dem mehrere HF-Refokussierungspulse (5) zur Erzeugung von mehreren Spinechos eingestrahlt werden, **dadurch gekennzeichnet, dass** alle HF-Refokussierungspulse (5) des Auslesemoduls (2) mit der lokalen Sendespule (22) eingestrahlt werden.

2. Verfahren nach Anspruch 1, **dadurch gekennzeichnet, dass**
die Bildgebungssequenz ein Präparationsmodul (1) vor dem Auslesemodul (2) aufweist, in dem die Magnetisierung des Untersuchungsobjekts (20) durch Einstrahlen von zumindest einem HF-Anregungspuls (4) präpariert wird, bevor das MR-Signal in dem Auslesemodul ausgelesen wird, und
der zumindest eine HF-Anregungspuls (4) mit der Ganzkörperspule (21) eingestrahlt wird.

3. Verfahren nach Anspruch 2, **dadurch gekennzeichnet, dass**
das Präparationsmodul (1) einen HF-Anregungspuls (4) aufweist, der mit der Ganzkörperspule (21) eingestrahlt wird, um eine Magnetisierung des Untersuchungsobjekts (20) für die Erzeugung der MR-Signale aus einer Gleichgewichtslage auszulenken.

4. Verfahren nach einem der Ansprüche 2 oder 3, **dadurch gekennzeichnet, dass**
das Präparationsmodul (1) einen HF-Präparationspuls (3) zur Unterdrückung unerwünschter Signalanteile im Auslesemodul (2) aufweist, der mit der Ganzkörperspule (21) eingestrahlt wird.

5. MR-Anlage zur Erstellung eines MR-Bildes eines Untersuchungsobjekts, welche aufweist:
- eine Ganzkörperspule (21), die ausgebildet ist, HF-Pulse (3, 4) zu erzeugen,
- eine lokale Sendespule/Empfangsspule (22), die ausgebildet ist, HF-Refokussierungspulse (5) zu erzeugen und Echosignale aus dem Untersuchungsobjekt (20) zu empfangen.
- eine HF-Steuereinheit (24), die ausgebildet ist, die HF-Pulse (3, 4) der Ganzkörperspule (21) und die HF-Pulse (5) der lokalen Sendespule/Empfangsspule (22) zu steuern, wobei die HF-Steuereinheit (24) nach Auswahl einer Bildgebungssequenz die Ganzkörperspule (21) und die lokale Sendespule/Empfangsspule (22) derart steuert, dass
die Ganzkörperspule (21) zumindest einen HF-Puls (4) während der Bildgebungssequenz einstrahlt, und
dass die lokale Sendespule/Empfangsspule (22) zumindest einen HF-Puls (5) während der Bildgebungssequenz einstrahlt,
- einen Bildrechner (25), der ausgebildet ist, aus den empfangenen Echodaten ein MR-Bild zu berechnen, wobei die Bildgebungssequenz ein Auslesemodul (2) aufweist, das mehrere HF-Refokussierungspulse (5) aufweist, **dadurch gekennzeichnet, dass** die HF-Steuereinheit (24) die lokale Sendespule/Empfangsspule (22) derart steuert, dass die lokale Sendespule/Empfangsspule (22) alle HF-Refokussierungspulse (5) des Auslesemoduls (2) zur Erzeugung von mehreren Spinechos einstrahlt.

6. MR-Anlage nach Anspruch 5, **dadurch gekennzeichnet, dass**
die Bildgebungssequenz ein Präparationsmodul (1) vor dem Auslesemodul (2) aufweist, wobei die HF-Steuereinheit (24) die Ganzkörperspule (21) derart steuert, dass die Ganzkörperspule (21) die Magnetisierung des Untersuchungsobjekts (20) dadurch präpariert, dass sie zumindest einen HF-Anregungspuls (4) einstrahlt.

7. MR-Anlage nach einem der Ansprüche 5 oder 6, **dadurch gekennzeichnet, dass**
das Präparationsmodul (1) einen HF-Anregungspuls (4) aufweist, wobei die HF-Steuereinheit (24) die Ganzkörperspule (21) derart steuert, dass die Ganzkörperspule (21) eine Magnetisierung des Untersuchungsobjekts (20) für die Erzeugung der MR-Signale aus einer Gleichgewichtslage auslenkt.

8. MR-Anlage nach einem der Ansprüche 5 bis 7, **dadurch gekennzeichnet, dass**
das Präparationsmodul (1) einen HF-Präparationspuls (3) aufweist, wobei die HF-Steuereinheit (24) die Ganzkörperspule (21) derart steuert, dass die Ganzkörperspule (21) einen HF-Präparationspuls (3) zur Unterdrückung unerwünschter Signalanteile im Auslesemodul (2) einstrahlt.

9. MR-Anlage nach einem der Ansprüche 5 bis 8, **dadurch gekennzeichnet, dass**
die Ganzkörperspule (21) den gesamten Untersuchungsbereich räumlich umschließt, und
die Ganzkörperspule (21) ausgestaltet ist, die HF-Pulse (3, 4) aus dem Anregungsmodul (1) zu erzeugen.

10. MR-Anlage nach einem der Ansprüche 5 bis 9, **dadurch gekennzeichnet, dass**
die lokale Sendespule/Empfangsspule (22) innerhalb des Untersuchungsbereichs frei positionierbar ist.

11. MR-Anlage nach einem der Ansprüche 5 bis 10, **dadurch gekennzeichnet, dass**
die Vorrichtung zur Durchführung des Verfahrens nach einem der Ansprüche 1-4 ausgestaltet ist.

## Claims

1. Method for creating an MR image of an examination object with an MR imaging sequence in an MR system, having the following steps:
- irradiating at least one HF pulse (3, 4) by means of a whole body coil (21) of the MR system during the imaging sequence,
- irradiating at least one HF pulse (5) by means of a local transmit coil (22) of the MR system during the imaging sequence,
- reading-out MR signals, which are generated by the irradiated HF pulses (3, 4, 5).
- creating the MR image from the read-out MR signals, wherein the imaging sequence has a read-out module (2), in which a number of HF refocusing pulses (5) are irradiated in order to generate a number of spin echos, **characterised in that** all HF refocusing pulses (5) of the read-out module (2) are irradiated with the local transmit coil (22).

2. Method according to claim 1, **characterised in that**
the imaging sequence has a preparation module (1) upstream of the read-out module (2), in which the magnetisation of the examination object (20) is prepared by irradiating at least one HF excitation pulse (4) before the MR signal is read out in the read-out module and
the at least one HF excitation pulse (4) is irradiated with the whole body coil (21).

3. Method according to claim 2, **characterised in that**
the preparation module (1) has an HF excitation pulse (4) which is irradiated with the whole body coil (21) in order to magnetise the examination object (20) for the generation of the MR signals from a position of equilibrium.

4. Method according to one of claims 2 or 3, **characterised in that**
the preparation module (1) has an HF preparation pulse (3) for suppressing unwanted signal parts in the read-out module (2), which is irradiated with the whole body coil (21).

5. MR system for creating an MR image of an examination object, which has:
- a whole body coil (21), which is embodied to generate HF pulses (3, 4),
- a local transmit coil/receive coil (22), which is embodied to generate HF refocusing pulses (5) and to receive echo signals from the examination object (20),
- an HF control unit (24), which is embodied to control the HF pulses (3, 4) of the whole body coil (21) and the HF pulses (5) of the local transmit coil/receive coil (22), wherein the HF control unit (24), after selecting an imaging sequence, controls the whole body coil (21) and the local transmit coil/receive coil (22) such that
the whole body coil (21) irradiates at least one HF pulse (4) during the imaging sequence and
the local transmit coil/receive coil (22) irradiates at least one HF pulse (5) during the imaging sequence,
- an image processor (25), which is embodied to calculate an MR image from the received echo data, wherein
the imaging sequence has a read-out module (2) which has a number of RF refocusing pulses (5), **characterised in that** the HF control unit (24) controls the local transmit coil/receive coil (22) such that the local transmit coil/receive coil (22) irradiates all HF refocusing pulses (5) of the read-out module (2) in order to generate a number of spin echos.

6. MR system according to claim 5, **characterised in that**
the imaging sequence has a preparation module (1) upstream of the read-out module (2), wherein the HF control unit (24) controls the whole body coil (21) such that the whole body coil (21) prepares the magnetisation of the examination object (20) such that it irradiates at least one HF excitation pulse (4) .

7. MR system according to one of claims 5 or 6, **characterised in that**
the preparation module (1) has an HF excitation pulse (4), wherein the HF control unit (24) controls the whole body coil (21) such that the whole body coil (21) deflects a magnetisation of the examination object (20) for the generation of the MR signals from a position of equilibrium.

8. MR system according to one of claims 5 to 7, **characterised in that**
the preparation module (1) has an HF preparation pulse (3), wherein the HF control unit (24) controls the whole body coil (21) such that the whole body coil (21) irradiates an HF preparation pulse (3) for suppressing unwanted signal parts in the read-out module (2).

9. MR system according to one of claims 5 to 8, **characterised in that**
the whole body coil (21) spatially encloses the entire examination region, and
the whole body coil (21) is configured to generate the HF pulses (3, 4) from the excitation module (1).

10. MR system according to one of claims 5 to 9, **characterised in that**
the local transmit coil/receive coil (22) can be positioned freely within the examination region.

11. MR system according to one of claims 5 to 10, **characterised in that**
the apparatus is configured to implement the method according to one of claims 1 - 4.

## Revendications

1. Procédé d'établissement d'une image RM d'un objet à examiner par une séquence d'imagerie RM dans une installation RM, comprenant les stades suivants :
- exposition à au moins une impulsion HF (3, 4) par une bobine (21) au corps entier de l'installation RM pendant la séquence d'imagerie,
- exposition à au moins une impulsion HF (5) par une bobine (22) locale d'émission de l'installation RM pendant la séquence d'imagerie,
- lecture de signaux RM, qui sont produits par les impulsions HF (3, 4, 5) d'exposition,
- établissement de l'image RM à partir des signaux RM lus, la séquence d'imagerie ayant un module (2) de lecture, dans lequel on expose à plusieurs impulsions HF (5) de refocalisation pour la production de plusieurs échos de spin, **caractérisé en ce que** l'on expose à toutes les impulsions HF (5) de refocalisation du module (2) de lecture par la bobine (22) locale d'émission.

2. Procédé suivant la revendication 1, **caractérisé**
**en ce que** la séquence d'imagerie a, avant le module (2) de lecture, un module (1) de préparation, dans lequel on prépare l'aimantation de l'objet (20) à examiner, par application d'au moins une impulsion HF (4) d'excitation avant de lire le signal RM dans le module de lecture, et
on expose à la au moins une impulsion HF (4) d'excitation par la bobine (21) au corps entier.

3. Procédé suivant la revendication 2, **caractérisé**
**en ce que** le module (1) de préparation a une impulsion HF (4) d'excitation, à laquelle on expose par le bobine (21) au corps entier, pour dévier d'une position d'équilibre une aimantation de l'objet (20) à examiner pour la production des signaux RM.

4. Procédé suivant l'une des revendications 2 ou 3, **caractérisé**
**en ce que** le module (1) de préparation a une impulsion HF (3) de préparation, pour supprimer des proportions non souhaitées du signal dans le module (2) de lecture, à laquelle on expose par la bobine (21) au corps entier.

5. Installation RM d'établissement d'une image RM d'un objet à examiner qui a :
- une bobine (21) au corps entier, qui est constituée pour produire des impulsions HF (3, 4),
- une bobine (22) locale d'émission / réception, qui est constituée pour produire des impulsions (5) de refocalisation et pour recevoir des signaux d'écho de l'objet (20) à examiner,
- une unité (24) de commande HF, qui est constituée, pour commander les impulsions HF (3, 4) de la bobine (21) au corps entier et les impulsions HF (5) de la bobine (22) locale d'émission / réception, dans laquelle l'unité (24) de commande HF commande suivant le choix d'une séquence d'imagerie la bobine (21) au corps entier et la bobine (22) locale d'émission / réception, de manière
à ce que la bobine (21) au corps entier expose à au moins une impulsion HF (4) pendant la séquence d'imagerie, et
à ce que la bobine (22) locale d'émission / réception expose à au moins une impulsion HF (5) pendant la séquence d'imagerie,
- un calculateur (25) d'image, qui est constitué pour calculer une image RM à partir des données d'écho reçues, dans laquelle
la séquence d'imagerie a un module (2) de lecture, qui a plusieurs impulsions HF (5) de refocalisation,
**caractérisé en ce que**
l'unité (24) de commande HF commande la bobine (22) locale d'émission / réception, de manière à ce que la bobine (22) locale d'émission / réception expose à toutes les impulsions HF (5) de refocalisation du module (2) de lecture pour la production de plusieurs échos de spin.

6. Installation RM suivant la revendication 5, **caractérisé en ce que**
la séquence d'imagerie a un module (1) de préparation avant le module (2) de lecture, dans laquelle l'unité (24) de commande HF commande la bobine (21) au corps entier, de manière à ce que la bobine (21) au corps entier prépare l'aimantation de l'objet (20) à examiner en exposant à au moins une impulsion HF (4) d'excitation

7. Installation RM suivant l'une des revendications 5 ou 6, **caractérisé en ce que**
le module (1) de préparation a une impulsion HF (4) d'excitation, dans laquelle l'unité (24) de commande HF commande la bobine (21) au corps entier, de manière à ce que la bobine (21) au corps entier dévie d'une position d'équilibre une aimantation de l'objet (20) à examiner pour la production des signaux RM.

8. Installation RM suivant l'une des revendications 5 à 7, **caractérisé en ce que**
le module (1) de préparation a une impulsion HF (3) de préparation, dans laquelle l'unité (24) de commande HF commande la bobine (21) au corps entier, de manière à ce que la bobine (21) au corps entier expose à une impulsion HF (3) de préparation pour la suppression de proportions non souhaitées du signal dans le module (2) de lecture.

9. Installation RM suivant l'une des revendications 5 à 8, **caractérisé en ce que**
la bobine (21) au corps entier entoure dans l'espace toute la région à examiner et
la bobine (21) au corps entier est conformée pour produire les impulsions HF (3, 4) à partir du module (1) d'excitation.

10. Installation RM suivant l'une des revendications 5 à 9, **caractérisé en ce que**
la bobine (22) locale d'émission / réception peut être mise en une position quelconque à l'intérieur de la région à examiner.

11. Installation RM suivant l'une des revendications 5 à 10, **caractérisé en ce que**
l'installation est conformée pour effectuer le procédé suivant l'une des revendications 1 à 4.
